# EUROPÄISCHE PATENTANMELDUNG

(11) **EP 1 107 313 A2**
(43) Veröffentlichungstag der Anmeldung: **13.06.2001**
(21) Anmeldenummer: 00125798.9
(22) Anmeldetag: 24.11.2000
(51) Int. Cl.: H01L 23/544, G03F 7/20

(54) **On-chip Testschaltung zur Kontrolle der Belichtungsmaskenreihenfolge**

(30) Priorität: 07.12.1999 DE 19958906
(71) Anmelder: Infineon Technologies AG, 81669 München (DE)
(72) Erfinder: Manyoki, Zoltan, Kanata, ON K2L 3W9 (CA)
(74) Vertreter: Fischer, Volker, Dipl.-Ing.

(57) **Zusammenfassung**

Die integrierte Schaltung (IC) weist in mehreren Verdrahtungsebenen (M1, M2, P) mit Hilfe von Belichtungsmasken (MSKi) erzeugte erste Strukturen (S1) auf, die zur Realisierung einer vom Verwender der Schaltung gewünschten Funktionalität dienen. Weiterhin weist sie in mehreren der Verdrahtungsebenen mit Hilfe der Belichtungsmasken (MSKi) erzeugte zweite Strukturen (S2) auf, die nicht der bestimmten Funktionalität, sondern der Überprüfbarkeit der Zugehörigkeit der verwendeten Belichtungsmasken zu einem gemeinsamen Maskensatz (MSKS) dienen.

## Beschreibung

Die Erfindung betrifft eine integrierte Schaltung sowie ein entsprechendes Herstellungsverfahren.

Zur Herstellung integrierter Schaltungen kommen Belichtungsmasken zum Einsatz, mit deren Hilfe fotoempfindliche Schichten strukturiert werden. Die strukturierten fotoempfindlichen Schichten dienen dann beispielsweise als Ätzbarrieren oder zur Erzeugung definierter Dotierprofile in darunter befindlichen Schichten der herzustellenden integrierten Schaltung. Insbesondere bei der Herstellung komplexer integrierter Schaltungen werden eine Vielzahl von Belichtungsmasken benötigt. Dabei werden alle diejenigen Belichtungsmasken, die zur Herstellung einer bestimmten integrierten Schaltung dienen, als ein zusammen gehöriger Maskensatz bezeichnet.

Während der Herstellung kommt es vor, dass Masken des zu verwendenden Maskensatzes mit anderen Masken verwechselt werden, die nicht zu dem Maskensatz gehören. Dies geschieht insbesondere dann, wenn eine verbesserte Version einer bereits existierenden Schaltung erzeugt werden soll, da dann der Maskensatz der neuen Schaltung sich nur geringfügig von dem Maskensatz der älteren Schaltung unterscheidet und auch die Anzahl der zu verwendenden Masken gleich ist. Kommt es nun zur Verwechselung einer der Masken des aktuell zu verwendenden Maskensatzes mit einer der Masken des anderen Maskensatzes, führt dies während des Betriebs der hergestellten Schaltung zu Fehlfunktionen, die bei einem Test der Schaltung nur schwer festzustellen sind oder nicht ohne weiteres auf ihre Fehlerursache zurückgeführt werden können, nämlich die Verwendung einer falschen Maske.

Der Erfindung liegt die Aufgabe zugrunde, das Vertauschen von Masken, die zur Herstellung von integrierten Schaltungen dienen, erkennbar zu machen. Diese Aufgabe wird mit einer integrierten Schaltung gemäß Anspruch 1 sowie einem Herstellungsverfahren gemäß Anspruch 5 gelöst. Vorteilhafte Aus- und Weiterbildungen der Erfindung sind Gegenstand der abhängigen Ansprüche.

Erfindungsgemäß werden neben ersten Strukturen, die zur Realisierung einer vom Verwender der Schaltung gewünschten Funktionalität dienen, während der Herstellung der Schaltung mit Hilfe der Belichtungsmasken zweite Strukturen erzeugt, die nicht der bestimmten Funktionalität, sondern lediglich der Überprüfbarkeit der Zugehörigkeit der verwendeten Belichtungsmasken zu einem gemeinsamen Maskensatz dienen, wobei die zweiten Strukturen in mehreren Verdrahtungsebenen der integrierten Schaltung angeordnet sind. Die ersten Strukturen umfassen dabei alle elektrischen Strukturen, die die gewünschte Funktionalität der Schaltung gewährleisten. Die ersten Strukturen können beispielsweise Teile von Widerständen, Kondensatoren oder Transistoren sein. Die zweiten Strukturen dagegen dienen nicht der vom Verwender der Schaltung gewünschten Funktionalität, sondern der Überprüfung, ob es sich bei den verwendeten Belichtungsmasken um die richtigen Masken gehandelt hat. Somit dienen die zweiten Strukturen dem Interesse des Herstellers der integrierten Schaltung, der mit Hilfe der zweiten Strukturen feststellen kann, ob die hergestellte Schaltung überhaupt fehlerfrei funktionieren kann, weil die richtigen, dem gemeinsamen Maskensatz zugeordneten Belichtungsmasken verwendet worden sind.

Nach einer Ausführungsform der Erfindung sind die zweiten Strukturen elektrisch auswertbar, so dass festgestellt werden kann, ob die bei der Herstellung verwendeten Belichtungsmasken dem gemeinsamen Maskensatz zugeordnet waren. Das bedeutet, dass die zweiten Strukturen elektrisch leitfähig sein müssen, um beispielsweise ihnen zugeführte Messströme leiten zu können.

Vorteilhaft ist es, wenn die integrierte Schaltung eine Auswerteeinheit zur Auswertung der zweiten Strukturen und zur Erzeugung eines entsprechenden Ergebnissignals aufweist, wobei das Ergebnissignal angibt, ob die bei der Herstellung verwendeten Belichtungsmasken zum gemeinsamen Maskensatz gehörten. Eine solche Auswerteeinheit, die auf der Schaltung integriert ist, ermöglicht einen Selbsttest der Schaltung bezüglich der Korrektheit der während der Herstellung verwendeten Masken.

Günstig ist es, wenn die Auswerteschaltung über das Ergebnissignal eine Fehlfunktion der Schaltung auslöst, sofern die für die Herstellung verwendeten Belichtungsmasken nicht zum gemeinsamen Maskensatz gehörten. Diese Fehlfunktion bezieht sich auf die vom Verwender der Schaltung gewünschte Funktionalität, die durch die ersten Strukturen gewährleistet wird. Daher greift die Auswerteschaltung bei dieser Weiterbildung der Erfindung in Funktionen der Schaltung ein, die durch die ersten Strukturen gewährleistet werden. Der Hersteller der Schaltung kann bei Auftreten dieser bestimmten Fehlfunktion dann darauf schließen, dass die Auswerteeinheit einen Fehler bei den für die Herstellung der Schaltung verwendeten Masken festgestellt hat.

Die Erfindung wird im folgenden anhand von in den Figuren dargestellten Ausführungsbeispielen näher erläutert. Es zeigen:
- Figur 1: eine erfindungsgemäße integrierte Schaltung in einer Querschnittdarstellung,
- Figur 2: das Prinzip des Auswertens von zweiten Strukturen der Schaltung sowie eine Auswerteeinheit der Schaltung,
- Figur 3: einen Herstellungsschritt zur Erzeugung der integrierten Schaltung sowie
- Figur 4: drei einem gemeinsamen Maskensatz zugeordnete Masken, die zur Herstellung der Schaltung dienen.

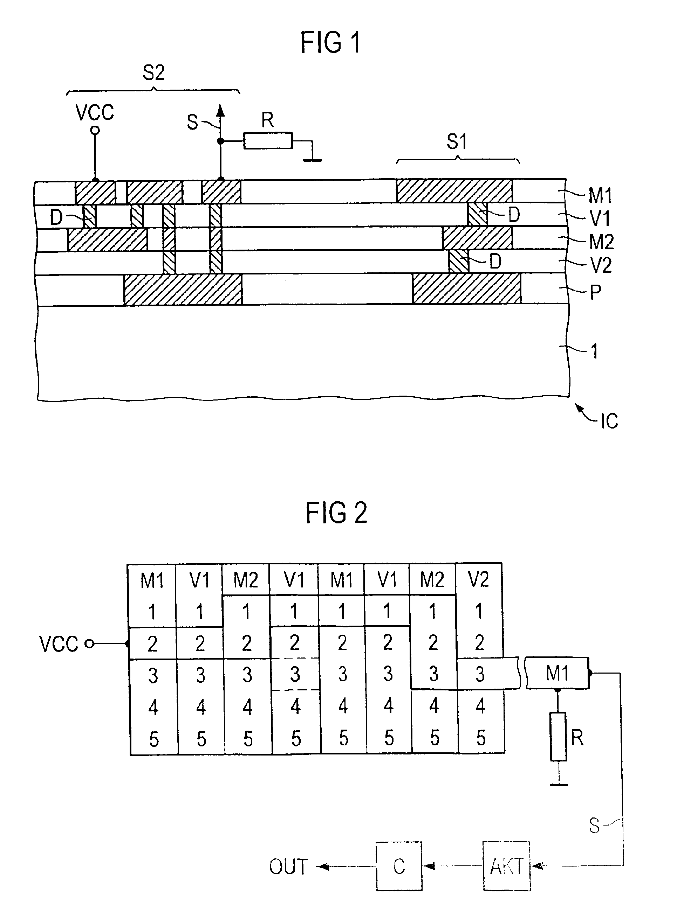

Figur 1 zeigt in einer Querschnittdarstellung eine integrierte Schaltung IC, die auf einem Substrat 1 mehrere Verdrahtungsebenen M1, M2, P aufweist. Unter den Verdrahtungsebenen ist eine erste Metallisierungsebene M1, eine zweite Metallisierungsebene M2 sowie eine Polysiliziumebene P. In den unterschiedlichen Verdrahtungsebenen sind erste Strukturen S1 sowie zweite Strukturen S2 angeordnet, die in der Figur 1 schraffiert dargestellt wurden. Diese Strukturen S1, S2 sind elektrisch leitfähig. Die in der Figur 1 nicht schraffierten Bereiche sind dagegen elektrisch isolierend. Zwischen je zwei der Verdrahtungsebenen M1, M2, P sind Isolierungsebenen V1, V2 angeordnet, in denen Durchkontaktierungen D erzeugt worden sind, die ebenfalls Bestandteil der ersten S1 bzw. zweiten Strukturen S2 sind und über die die in den Verdrahtungsebenen M1, M2, P angeordneten leitfähigen Strukturen miteinander verbunden sind.

Die ersten Strukturen S1 bilden gemeinsam eine elektrische Schaltung, die zur Realisierung der vom Verwender gewünschten Funktionalität der integrierten Schaltung dienen. Hierzu gehören beispielsweise durch die ersten Strukturen gebildete Widerstände, Transistoren, Kondensatoren usw..

Die zweiten Strukturen S2 bilden einen zusammenhängenden, elektrisch leitfähigen Signalpfad, dessen eines Ende mit einem positiven Versorgungspotential VCC und dessen anderes Ende über einen Widerstand R mit Masse verbunden ist. Am vom Masse abgewandten Anschluss des Widerstands R liefert dieser Signalpfad ein Ergebnissignal S, dessen Pegel davon abhängt, ob der Signalpfad das Versorgungspotential VCC und den Widerstand R durchgehend miteinander verbindet, oder ob er eine Unterbrechung aufweist. Im erstgenannten Fall hat das Ergebnissignal S den Wert des Versorgungspotentials VCC, im letztgenannten Fall ist es gleich Masse. Der Widerstand R ist also ein Pull-Down-Widerstand.

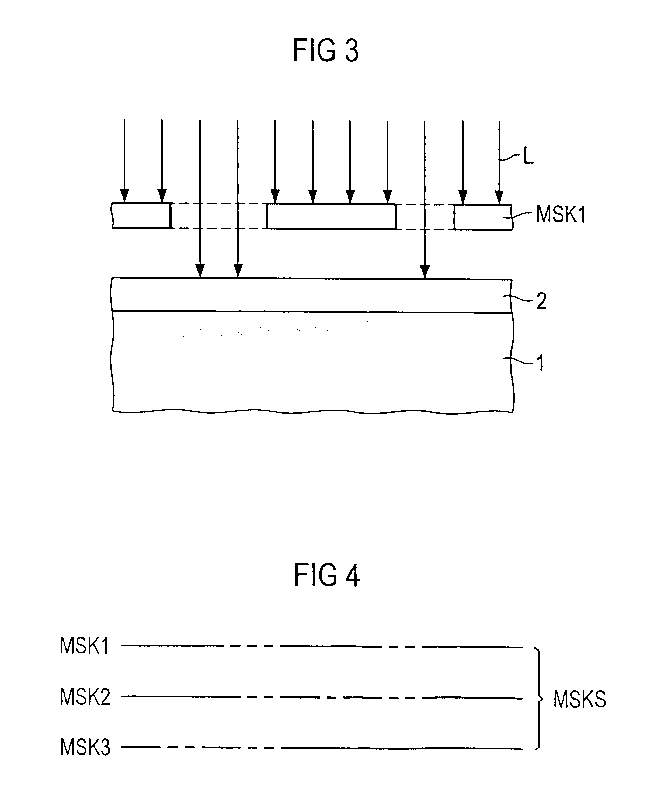

Figur 3 ist zu entnehmen, dass die einzelnen ersten Strukturen S1 und zweiten Strukturen S2 aus Figur 1 unter Verwendung von Belichtungsmasken MSK1 hergestellt werden. Figur 3 zeigt beispielhaft lediglich einen von zahlreichen Herstellungsschritten, in dem lediglich eine erste Maske MSK1 zum Einsatz kommt. Dabei ist auf das Substrat 1 eine fotoempfindliche Schicht 2 aufgetragen, die mittels durch die erste Maske MSK1 auftreffendes Licht L gezielt belichtet wird.

Figur 4 zeigt, dass alle für die Herstellung der integrierten Schaltung benötigten Masken, von denen in Figur 4 lediglich drei MSK1 bis MSK3 dargestellt wurden, einem gemeinsamen Maskensatz MSKS zugeordnet sind. Werden während der Herstellung diese Masken MSKi in der richtigen Reihenfolge eingesetzt, werden die in Figur 1 gezeigten Strukturen S1, S2 erzeugt. Dann wird der in Figur 1 erkennbare zusammenhängende Signalpfad durch die zweiten Strukturen S2 gebildet und das Ergebnissignal S hat den Wert des Versorgungspotentials VCC. Wird dagegen eine oder werden mehrere der Masken MSKi des Maskensatzes MSKS durch Masken eines anderen, nicht für die Herstellung dieser speziellen integrierten Schaltung vorgesehenen Maskensatzes ersetzt, ergibt sich bei der Herstellung eine andere gegenseitige Anordnung der zweiten Strukturen S2, so dass kein zusammenhängender Signalpfad entsteht und das Ergebnissignal S Massepotential aufweist. Voraussetzung hierfür ist allerdings, dass jedem für die Herstellung einer speziellen integrierten Schaltungen vorgesehenen Maskensatz MSKS ein eigener "Identifikationscode" zugeordnet ist, der zur Folge hat, dass sich die Masken MSKi jedes Maskensatzes MSKS von denjenigen anderer Maskensätze in ihrer Gestalt unterscheiden, so daß bei Verwendung unterschiedlicher Maskensätze MSKS jeweils unterschiedliche zweite Strukturen S2, die dem jeweiligen Identifikationscode des Maskensatzes MSKS entsprechen, ergeben.

Anhand von Figur 2 soll noch einmal erläutert werden, was mit dem zuvor Gesagten gemeint ist. Bei der Figur 2 handelt es sich um eine lediglich symbolische Darstellung, also um keine Querschnittsdarstellung. Dargestellt ist ein Ausschnitt des sich zwischen dem Versorgungspotential VCC und dem Widerstand R in Figur 1 erstreckenden Signalpfades. Der Signalpfad, der durch die in den unterschiedlichen Ebenen M1, M2, P, V1, V2 erzeugten zweiten Strukturen S2 gebildet ist, ist nur dann durchgehend, wie dies in den Figuren 1 und 2 gezeigt ist, wenn die zweiten Strukturen S2 entsprechend zueinander angeordnet sind. Wäre beispielsweise die in der vierten Spalte des in Figur 2 eingetragenen Kastens symbolisierte zweite Struktur S2 in der ersten Isolierungsebene V1 nicht an der Position 1, sondern an der Position 3 (gestrichelt angedeutet) angeordnet, ergäbe sich ein nicht zusammenhängender Signalpfad, so dass das Ergebnissignal S Massepegel hätte. Durch die Vergabe individueller Identifikationscodes an die unterschiedlichen Maskensätze MSKS muss gewährleistet sein, dass sich ein zusammenhängender Signalpfad nur ergibt, wenn alle verwendeten Masken demselben Maskensatz MSKS angehören.

Figur 2 ist auch zu entnehmen, dass die integrierte Schaltung IC eine Teilschaltung C (die durch die ersten Strukturen Sl realisiert ist) aufweist, die während ihres Betriebs Ausgangssignale an einen Ausgang OUT der integrierten Schaltung liefert. Weiterhin weist die integrierte Schaltung eine Deaktivierungsschaltung AKT auf, die bei einem niedrigen Pegel des Ergebnissignals S (das heißt, wenn kein zusammenhängender Signalpfad zwischen dem Versorgungspotential VCC und dem Widerstand R vorhanden ist, also während der Herstellung der integrierten Schaltung zumindest eine verkehrte Maske MSKi verwendet worden ist) die Funktionsweise der Teilschaltung so beeinflusst, dass dort eine Fehlfunktion auftritt. Diese Fehlfunktion hat zur Folge, dass die Teilschaltung C nicht die im normalen Betrieb vorgesehenen Signale an den Ausgang OUT ausgibt, sondern davon abweichende Signale. Sie kann auch beispielsweise aufgrund der Fehlfunktion einfach den Ausgang OUT hochohmig schalten, wenn dies im Normalbetrieb nicht vorgesehen ist. In jedem Fall muss diese Fehlfunktion eindeutig von außerhalb der integrierten Schaltung erkennbar und dem aufgetretenen Fehler zuzuordnen sein. Dann kann bei Auftreten der Fehlfunktion von außerhalb der integrierten Schaltung IC darauf geschlossen werden, dass ein Fehler bei der Maskenzuordnung während der Herstellung der Schaltung aufgetreten ist.

Durch die Erfindung ist nicht nur feststellbar, ob nur solche Belichtungsmasken während der Herstellung verwendet wurden, die dem richtigen Maskensatz MSKS zugeordnet sind, sondern auch, ob diese Masken bei den einzelnen Herstellungsschritten der integrierten Schaltung in der richtigen Reihenfolge verwendet wurden.

Die Erfindung ist nicht nur auf elektrische integrierte Schaltungen anwendbar, sondern beispielsweise auch auf integrierte Schaltungen, die mikromechanische Komponenten enthalten.

## Patentansprüche

1. Integrierte Schaltung (IC), die eine bestimmte, von einem Verwender der Schaltung gewünschte Funktionalität aufweist,
- die in mehreren Verdrahtungsebenen (M1, M2, P) mit Hilfe von Belichtungsmasken (MSKi) erzeugte erste Strukturen (Sl) aufweist, die zur Realisierung der bestimmten Funktionalität dienen,
- und die in mehreren der Verdrahtungsebenen mit Hilfe der Belichtungsmasken (MSKi) erzeugte zweite Strukturen (S2) aufweist, die nicht der bestimmten Funktionalität, sondern der Überprüfbarkeit der Zugehörigkeit der verwendeten Belichtungsmasken zu einem gemeinsamen Maskensatz (MSKS) dienen.

2. Integrierte Schaltung nach Anspruch 1,
deren zweite Strukturen (S2) elektrisch auswertbar sind, so dass festgestellt werden kann, ob die bei der Herstellung verwendeten Belichtungsmasken (MSKi) dem gemeinsamen Maskensatz (MSKS) zugeordnet waren.

3. Integrierte Schaltung nach Anspruch 2
mit einer Auswerteeinheit (R, AKT) zur Auswertung der zweiten Strukturen (S2) und zur Erzeugung eines entsprechenden Ergebnissignals (S), das angibt, ob die bei der Herstellung verwendeten Belichtungsmasken (MSKi) zum gemeinsamen Maskensatz (MSKS) gehörten.

4. Integrierte Schaltung nach Anspruch 3,
deren Auswerteschaltung (R, AKT) über das Ergebnissignal (S) eine Fehlfunktion der Schaltung (IC) auslöst, sofern die für die Herstellung verwendeten Belichtungsmasken (MSKi) nicht zum gemeinsamen Maskensatz (MSKS) gehörten.

5. Herstellungsverfahren für eine integrierte Schaltung (IC), die eine bestimmte, von einem Verwender der Schaltung gewünschte Funktionalität aufweist,
- bei dem mit Hilfe von Belichtungsmasken (MSKi) in mehreren Verdrahtungsebenen (M1, M2, P) der herzustellenden Schaltung erste Strukturen (S1) erzeugt werden, die zur Realisierung der bestimmten Funktionalität dienen,
- und bei dem mit Hilfe der Belichtungsmasken (MSKi) in mehreren der Verdrahtungsebenen zweite Strukturen (S2) erzeugt werden, die nicht der bestimmten Funktionalität, sondern der Überprüfbarkeit der Zugehörigkeit der verwendeten Belichtungsmasken zu einem gemeinsamen Maskensatz (MSKS) dienen.

6. Herstellungsverfahren nach Anspruch 5,
bei dem die erzeugten zweiten Strukturen (S2) dahingehend überprüft werden, ob alle bei der Herstellung verwendeten Belichtungsmasken (MSKi) dem gemeinsamen Maskensatz (MSKS) zugeordnet waren.
